# EUROPÄISCHE PATENTSCHRIFT

(11) **EP 2 817 120 B1**
(45) Veröffentlichungstag und Bekanntmachung des Hinweises auf die Patenterteilung: **02.10.2019**
(21) Anmeldenummer: 13706488.7
(22) Anmeldetag: 21.02.2013
(51) Int. Cl.: B23K 1/00, B23K 1/19, H01R 43/02, H01R 4/02

(54) **VERFAHREN ZUM TECHNOLOGISCH OPTIMIERTEN AUSFÜHREN VON LÖTVERBINDUNGEN**
METHOD FOR CARRYING OUT SOLDER CONNECTIONS IN A TECHNOLOGICALLY OPTIMIZED MANNER
PROCÉDÉ PERMETTANT LA MISE EN OEUVRE TECHNOLOGIQUEMENT OPTIMISÉE DE LIAISONS BRASÉES

(30) Priorität: 24.02.2012 DE 102012003804; 18.04.2012 DE 102012007804
(43) Veröffentlichungstag der Anmeldung: 31.12.2014
(73) Patentinhaber: FEW Fahrzeugelektrikwerk GmbH & Co. KG, 04442 Zwenkau (DE)
(72) Erfinder: JENRICH, Andrè, 04442 Zwenkau (DE)
(74) Vertreter: Kruspig, Volkmar
(86) Internationale Anmeldenummer: PCT/EP2013/053458
(87) Internationale Veröffentlichungsnummer: WO 2013/124356

(56) Entgegenhaltungen:
- DE-U1-202011 100 906
- US-A- 4 801 069
- US-A- 5 439 160
- US-B1- 6 799 712

## Beschreibung

Die Erfindung betrifft ein Verfahren zum technologisch optimierten Ausführen von bleifreien Lötverbindungen, wobei wenigstens einer der Fügepartner das zur Verbindung erforderliche Lot bereitstellt, zur Aktivierung des Lotes ein Flussmittel zum Einsatz kommt und die elektrische sowie mechanische Verbindung durch einen Lötprozess mittels Wärmeeinwirkung und Aufschmelzen des Lot-Flussmittelgemischs einschließlich nachfolgender Abkühlphase erfolgt, gemäß Anspruch 1.

Aus der DE 102 03 112 A1 ist ein Verfahren zur Verbesserung der Qualität von Lötverbindungen vorbekannt. Bei dem dortigen Lösungsansatz geht es um das Verlöten großflächiger SMD-Bauelemente mit Verdrahtungsträgern, bei denen die Fügepartner durch Aufschmelzlöten miteinander elektrisch und mechanisch verbunden werden. Zur Aktivierung des Lotes kommt ein Flussmittel zum Einsatz.

In der DE 102 03 112 A1 wird auf die Problematik der organischen Bestandteile der Lotpaste aufmerksam gemacht. Nicht für die chemische Aktivierung der Fügepartner verbrauchte Bestandteile können sich während des Lötvorgangs in und um die Lötverbindung verteilen. Die innerhalb der entstehenden Lötverbindung verbleibenden organischen Bestandteile formieren sich während des Lötvorgangs zu mit Flüssigkeit oder Dampf gefüllten Blasen und steigen aufgrund ihres Auftriebs in die oberen Bereiche der Lötverbindung auf. Dies hat zur Folge, dass die Blasen während des Durchlaufens durch einen Lötofen je nach Lage der Baugruppe auf die meist flächigen Bauelementeanschlüsse oder die Flächen der Bauelementeunterseite treffen. Derartige Blasen führen zu Fehlstellen im Lötkontakt, d.h. die elektrische und mechanische Funktion der Lötverbindung wird beeinträchtigt. Um diesen Nachteil zu vermeiden, kann das Design der Fügepartner verändert werden, indem z.B. die Form und die Lage eines Lötstofflacks um die Fügestelle verändert wird, um einen Stau der austretenden Blasen zu vermeiden. Auch wurde bereits versucht, eine Veränderung des Aufschmelzprofils umzusetzen, wobei ein langsameres oder schnelleres Ansteigen der Temperaturen und eine Veränderung der Peaktemperatur den Blasen Zeit zum Aufsteigen und zum seitlichen Austreten aus der Metallschmelze gibt. Nachteilig ist jedoch die dabei eintretende erhöhte thermische Belastung der Baugruppe.

Um die Qualität der Lötverbindungen zu verbessern, zeigt die DE 102 03 112 A1 den Ansatz auf, die Fügepartner wenigstens während des Aufschmelzvorgangs der Lotpaste gegenüber der Normalebene in einen vorgegebenen Kippwinkel zu überführen. Darüber hinaus sollen die Fügepartner wiederholt durch einen Lötofen transportiert werden.

Die vorstehenden Maßnahmen zeigen zwar bezogen auf das Reduzieren der Anzahl von Fehlstellen Verbesserungen, jedoch verkompliziert sich die technologische Abfolge und es vergrößert sich die Taktzeit bei entsprechenden Lötvorgängen.

Aus der DE 20 2011 100 906 U1 ist ein Verfahren zum Ausführen von bleifreien Lötverbindungen offenbart, wobei einer der Fügepartner eine auf einem Glasmaterial aufgebrachte metallische Fläche und ein weiterer der Fügepartner ein elektrisches Anschlussmittel, bestehend aus einer Eisen-Nickel-Legierung ist.
Bei elektrischen Anschlüssen, die auf eine Verglasung, insbesondere Automobilverglasung aufzulöten sind, wurde bisher auf Kupfermaterialien zurückgegriffen. Kupfermaterial als Anschlusselement hat jedoch den Nachteil, dass sich die Ausdehnung bei Temperaturveränderung anders verhält als diejenige des Glases, bedingt durch den entsprechenden Ausdehnungskoeffizienten.

Der hierbei auftretende mechanische Stress kann zu Bruchstellen im Glas führen. Diese nachteiligen Effekte wurden bisher durch den Einsatz besonderer und duktiler bleihaltiger Lötlegierungen ausgeglichen. Zunehmend besteht jedoch die Forderung, auf Blei zu verzichten, d.h. bleifreie Lötlegierungen einzusetzen, was jedoch technologische Probleme entstehen lässt.

Grundsätzlich kommen als Materialien, die einen ähnlichen Ausdehnungskoeffizienten wie Fahrzeugglas besitzen, u.a. Eisen-Nickel-Legierungen und Edelstähle in Betracht. Die Wärmeleitfähigkeit dieser Materialien ist jedoch deutlich schlechter als diejenige von Kupfer. Das Erwärmen eines aus z.B. als Nickellegierungen hergestellten elektrischen Anschlusses inklusive der Lotlegierung benötigt daher eine höhere Taktzeit und/oder mehr Wärmeenergie.

Hieraus resultiert quasi ein Wärmetransport-Dämpfungseffekt, d.h. die Energie wird ausgehend von der Wärmequelle signifikant langsamer an die Wärmesenke, d.h. das Lötzinn und die entsprechende Kontaktfläche auf der Scheibe abgegeben.

Darüber hinaus ist der Liquiduspunkt bleifreier Legierungen mit ca. 120°C bis ca. 170°C signifikant niedriger als derjenige von bleihaltigen Legierungen, welcher im Bereich zwischen 200°C bis 300°C liegt.

Aus dem Vorgenannten ergeben sich daher höhere Aufwendungen bei der Durchführung von Lötprozessen im Sinne eines höheren Energieeinsatzes, einer größeren Arbeitszeit und daraus resultierend eine Einschränkung bezüglich der Maschinenkapazität. Letztendlich besteht eine nicht zu vernachlässigende Glasbruchgefahr. Es hat sich im Übrigen gezeigt, dass die Bruchempfindlichkeit des üblicherweise im Automotivbereich verwendeten Glases hinsichtlich größerer Temperaturunterschiede die Möglichkeit beschränkt, die an sich naheliegende Maßnahme der Erhöhung der Wärmeenergie, d.h. der diesbezüglichen Leistung zu nutzen.

Bleifreie Lote verbinden sich im Übrigen wesentlich schlechter mit den üblicherweise aufgebrachten leitfähigen Kontaktflächen auf dem Glasmaterial, z.B. in Form eines Silberdrucks. Lötkehlen bilden sich schwierig aus und es entsteht die Gefahr, dass das Lötzinn spritzt oder sich Lötperlen ausbilden, was wiederum zu einer reduzierten mechanischen und elektrischen Festigkeit zwischen den Fügepartnern führt.

Aus dem Vorgenannten ist es daher Aufgabe der Erfindung, ein weiterentwickeltes Verfahren zum technologisch optimierten Ausführen von bleifreien Lötverbindungen anzugeben, wobei wenigstens einer der Fügeparameter das zur Verbindung erforderliche Lot bereitstellt, zur Aktivierung des Lotes ein Flussmittel zum Einsatz kommt und die elektrische sowie mechanische Verbindung durch einen Lötprozess mittels Wärmeeinwirkung und Aufschmelzen des Lot-Flussmittelgemischs einschließlich nachfolgender Abkühlphase erfolgt sowie hierbei die Gefahr eines Glasbruchs reduziert wird und insgesamt eine Erhöhung der Lottaktzeit im Vergleich zu bisher angewendeten Verfahren vermieden werden kann.

Die Lösung der Aufgabe der Erfindung erfolgt durch eine Lehre gemäß dem Anspruch 1, wobei die Unteransprüche mindestens zweckmäßige Ausgestaltungen und Weiterbildungen darstellen.

Bei dem erfindungsgemäßen Verfahren zum technologisch optimierten Ausführen von bleifreien Lötverbindungen, stellt wenigstens einer der Fügepartner das zur Verbindung erforderliche Lot bereit. Dies geschieht beispielsweise dadurch, dass ein bleifreies Lötzinn auf eine Aderendhülse oder einen Lötfuß im Vorfeld aufgebracht wurde. Weiterhin kommt ein Flussmittel zum Einsatz, das bereits im Lötzinn enthalten ist oder separat aufgebracht werden kann.

Die eigentliche Lötverbindung erfolgt durch einen Lötprozess mittels Wärmeeinwirkung und Aufschmelzen des Lot-Flussmittelgemischs mit dann anschließender Abkühlung und Erstarrung.

Erfindungsgemäß werden die Fügepartner und das Lot in einer ersten Temperaturbehandlungsphase bis auf eine Temperatur unterhalb der Aktivierungstemperatur des Lotes und des Flussmittels erwärmt.

Hieran schließt sich erfindungsgemäß eine zweite Temperaturbehandlungsphase an, in der eine weitere Erwärmung auf eine Temperatur oberhalb der Aktivierungstemperatur des Flussmittels bis zum oberen Bereich der Schmelzstrecke des Lotes erfolgt. In diesem Schritt schmilzt das Lot auf und beginnt, sich mit den jeweiligen Fügepartnern zu verbinden.

Erfindungsgemäß wird weiterhin zum Zweck der Beschleunigung des Adhäsionsverhaltens der Fügeparameter während des Lötprozesses in einer dritten Temperaturbehandlungsphase eine Steigerung der bisher zur Einwirkung gebrachten thermischen Leistung oder Energie um weitere 5% bis 30% vorgenommen.

Einer der Fügepartner ist erfindungsgemäß eine auf einem Glasmaterial aufgebrachte metallische Fläche, insbesondere eine Silberdruck-Kontaktfläche, z.B. für einen Heizfeld- oder Antennenanschluss eines Kraftfahrzeugs.

Ein weiterer der Fügepartner ist erfindungsgemäß ein elektrisches Anschlussmittel, bestehend bevorzugt aus einer Eisen-Nickel-Legierung. Als elektrische Anschlussmittel können Aderendhülsen, Lötbrücken oder Lötfüße eingesetzt werden. Als bevorzugtes elektrisches Anschlussmittel stellt sich eine Aderendhülse nach DE 20 2008 015 165 U1 dar.

Der Temperaturbereich der ersten Behandlungsphase liegt bei einer bevorzugten Ausführungsform im Wesentlichen zwischen 80°C und 120°C. Der Temperaturbereich der zweiten Temperaturbehandlungsphase liegt bei einer bevorzugten Ausführungsform im Wesentlichen zwischen >120°C und 200°C.

Die vorerwähnten Temperaturbehandlungsphasen enden dann, wenn eine gleichmäßige Ausbildung von Lotkehlen zwischen den Fügepartnern vorliegt bzw. erkennbar ist.

Die erfindungsgemäße Lehre dient demnach der Verbesserung der Adhäsion des Lötzinns mit der Silberdruck-Kontaktfläche und reduziert den Stress des Basismaterials, d.h. des Glases durch abrupte Temperaturwechsel.

Die Erfindung soll nachstehend anhand eines Ausführungsbeispiels sowie unter Zuhilfenahme von Figuren näher erläutert werden.

Hierbei zeigen:
- Fig. 1: einen beispielhaften Querschnitt und eine Draufsicht eines Kabelendes mit Aderendhülse als beispielhaften Fügepartner, wobei das Kabelende eine Kupferlitze ist, die mit der Aderendhülse verpresst wurde und wobei weiterhin eine Freifläche der Aderendhülse eine Beschichtung mit bleifreiem Lötzinn aufweist;
- Fig. 2: eine Seitenansicht sowie eine Draufsicht auf einen Lötfuß in Form einer angenommenen Acht einschließlich einer an der Unterseite des Lötfußes vorhandenen bleifreien Lötzinnbeschichtung sowie eine Schnittdarstellung längs der Linie A-A und
- Fig. 3: ein Diagramm des Leistungs- bzw. Energieverlaufs über der Zeit mit den drei Temperaturbehandlungsphasen einschließlich schnellem Abkühlvorgang am Ende der Phase 3.

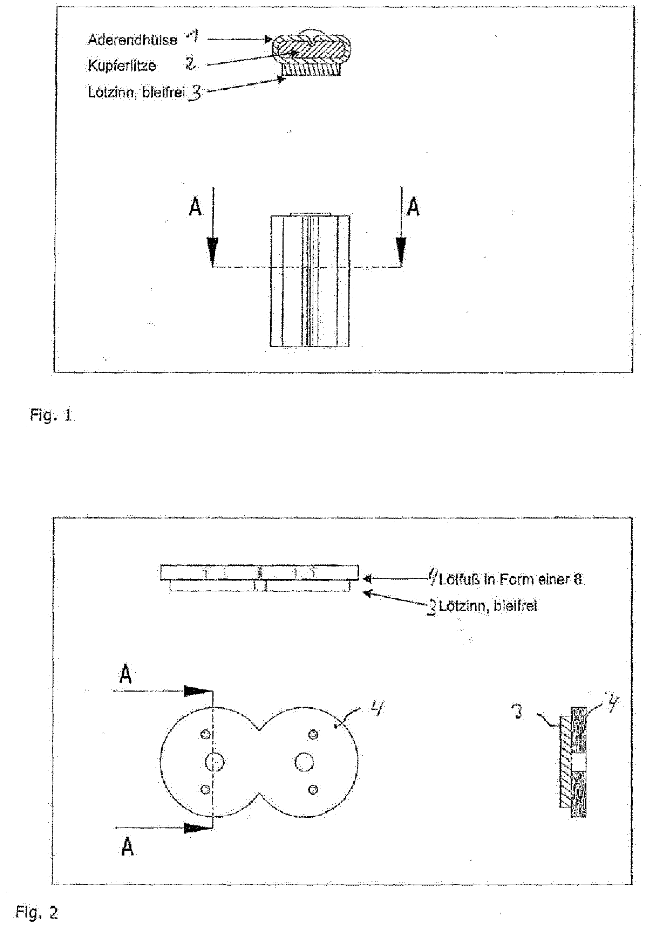

Als Fügepartner können Aderendhülsen 1 gemäß Fig. 1 zur Anwendung kommen. Die Aderendhülsen 1 nehmen ein abisoliertes Kupferlitzenende 2 eines in der Figur nicht gezeigten Kabels auf. Das Kupferlitzenende 2 ist bevorzugt durch Crimpen mit der Aderendhülse 1 verbunden.

An einer freien Unterseite der Aderendhülse 1 befindet sich eine Schicht aus bleifreiem Lötzinn 3.

Bei dem Fügepartner, ausgebildet als Lötfuß in Form einer Acht (Bezugszeichen 4) nach Fig. 2, befindet sich ebenfalls an der Unterseite des Lötfußes 4 eine Schicht aus bleifreiem Lötzinn 3.

Die Aderendhülsen, z.B. als Antennenanschlüsse gemäß Fig. 1, können nach der Lehre gemäß DE 20 2008 015 165 U1 realisiert sein. Die Anschlüsse in Form eines Lötfußes 4 nach Fig. 2 können gemäß der Lehre nach DE 20 2011 100 906 U1 ausgeführt werden.

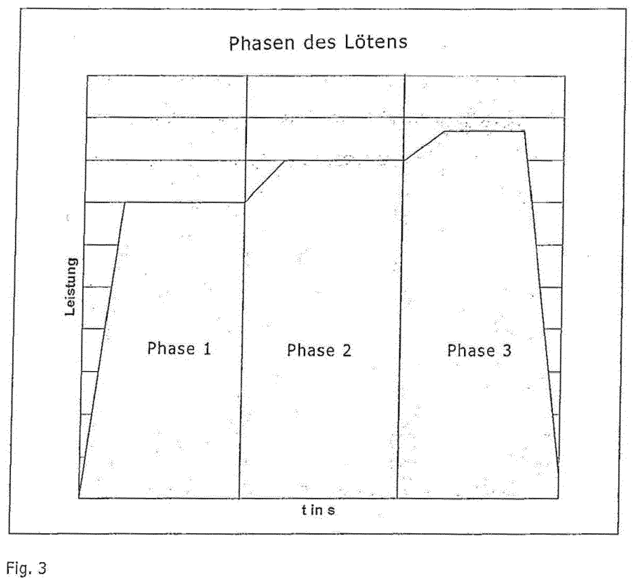

Die drei maßgeblichen Phasen des Lötprozesses, wie in Fig. 3 dargestellt, laufen wie folgt ab.

In einer ersten Phase erfolgt ein Erwärmen des elektrischen Anschlusses, des Lötzinns und des auf der entsprechenden Glasscheibe aufgebrachten Silberdrucks unterhalb der Aktivierungstemperatur des Flussmittels und oberhalb des Temperaturpunkts, an dem das Lötzinn beginnt flüssig zu werden. Hierbei wird das System gleichmäßig erwärmt, ohne dass das Flussmittel bereits diffundiert.

In einer zweiten Phase wird das System auf eine Temperatur erwärmt, die oberhalb der Aktivierungstemperatur des Flussmittels und dem oberen Bereich der Schmelzstrecke des Lötzinns liegt.

Hierbei wird das Flussmittel aktiviert und löst die Oxidationsschichten, die sich auf dem Silberdruck und auf dem Lötzinn selbst befinden. Das Lötzinn wird flüssig und beginnt sich mit der Legierung des Silberdrucks zu verbinden.

In der dritten Phase wird eine erfindungsgemäße Steigerung der Leistungseinbringung um weitere 5% bis 30% vorgenommen, um das Adhäsionsverhalten der Fügepartner zu beschleunigen.

Die thermische Behandlungsdauer endet dann, wenn sich Lötkehlen gleichmäßig ausgebildet haben.

Gemäß einem Ausführungsbeispiel der Erfindung liegt die Zeitdauer der ersten Phase im Bereich von 0,5 bis 3 Sekunden, die Zeitdauer der zweiten Phase im Bereich von 0,5 bis 4 Sekunden und die Zeitdauer der dritten Phase im Bereich von 0,5 bis 5 Sekunden. Bei einem bevorzugten Ausführungsbeispiel verläuft die Phase 1 über einen Zeitraum von ca. 1,5 bis 1,8 Sekunden. Es schließt sich daran die zweite Phase an, welche ausgehend vom Startzeitpunkt, d.h. dem Beginn der ersten Phase, im Bereich >1,5 bis 1,8 Sekunden bis ca. 6 Sekunden liegt. Die anschließende dritte Phase beginnt dann nach Ablauf der 6. Sekunde und dauert bis zur 8,5. Sekunde an.

Erfindungsgemäß liegt der Leistungsverlauf der ersten Phase im Bereich zwischen 150 und 350 Watt, der Leistungsverlauf der zweiten Phase im Bereich zwischen 160 und 400 Watt und der Bereich der dritten Phase zwischen 170 und maximal 500 Watt.

## Patentansprüche

1. Verfahren zum technologisch optimierten Ausführen von bleifreien Lötverbindungen, wobei wenigstens einer der Fügepartner das zur Verbindung erforderliche Lot bereitstellt, wobei einer der Fügepartner eine auf einem Glasmaterial aufgebrachte metallische Fläche und ein weiterer der Fügepartner ein elektrisches Anschlussmittel, bestehend aus einer Eisen-Nickel-Legierung ist, **dadurch gekennzeichnet dass**,
zur Aktivierung des Lotes ein Flussmittel zum Einsatz kommt und die elektrische sowie mechanische Verbindung durch einen Lötprozess mittels Wärmeeinwirkung und Aufschmelzen des Löt- und Flussmittelgemischs einschließlich nachfolgender Abkühlphase erfolgt,
die Fügepartner und das Lot in einer ersten Temperaturbehandlungsphase im Zeitdauerbereich von 0,5 bis 3 Sekunden bis auf eine Temperatur unterhalb der Aktivierungstemperatur des Lotes und des Flussmittels erwärmt werden, hieran anschließend in einer zweiten Temperaturbehandlungsphase im Zeitdauerbereich von 0,5 bis 4 Sekunden eine weitere Erwärmung auf eine Temperatur oberhalb der Aktivierungstemperatur des Flussmittels bis zum oberen Bereich der Schmelzstrecke des Lotes erfolgt, wobei das Lot aufschmilzt und sich mit den jeweiligen Fügepartnern beginnt zu verbinden, sowie
weiterhin zum Zweck der Beschleunigung des Adhäsionsverhaltens der Fügepartner in einer dritten Temperaturbehandlungsphase im Zeitdauerbereich von 0,5 bis 5 Sekunden eine Steigerung der bisher zur Einwirkung gebrachten thermischen Leistung oder Energie um weitere 5% bis 30% vorgenommen wird,
wobei ein Leistungsverlauf in der ersten Phase im Bereich zwischen 150 und 350 Watt, der Leistungsverlauf in der zweiten Phase im Bereich zwischen 160 und 400 Watt und der Leistungsbereich in der dritten Phase zwischen 170 und maximal 500 Watt liegt und
die dritte Temperaturbehandlungsphase dann endet, wenn eine gleichmäßige Ausbildung von Lötkehlen zwischen den Fügeparametern erkennbar ist.

2. Verfahren nach Anspruch 1,
**dadurch gekennzeichnet, dass**
als elektrisches Anschlussmittel Aderendhülsen, Lötbrücken oder Lötfüße eingesetzt werden.

3. Verfahren nach einem der vorangegangenen Ansprüche,
**dadurch gekennzeichnet, dass**
der Temperaturbereich der ersten Behandlungsphase zwischen im Wesentlichen 90° und 120°C und der Temperaturbereich der zweiten Temperaturbehandlungsphase zwischen >120°C und 200°C liegt.

4. Verfahren nach einem der vorangegangenen Ansprüche,
**dadurch gekennzeichnet, dass**
die Temperaturbehandlungsphasen eine Temperaturhaltephase einschließen.

## Claims

1. A method for performing technologically optimized lead free solder connections wherein at least one of the joining partners provides a solder that is required for the connection,
wherein one of the joining partners is a metal surface that is applied to a glass material and another joining partner is an electrical connecting device made from an iron nickel alloy,
**characterized in that**
a flux agent is used for activating the solder and an electrical and mechanical connection is performed by a soldering process by heat impact and melting of a solder and flux agent mix including a subsequent cool down phase,
the joining partners and the solder are heated in a first temperature treatment phase in a time period of 0.5 to 3 seconds to a temperature below an activation temperature of the solder and the flux agent and thereafter a second temperature treatment phase is performed in a time period of 0.5 - 4 seconds where an additional heating is performed to a temperature above an activation temperature of the flux agent up to an upper portion of a melting range of the solder wherein the solder melts and starts to connect with the respective joining partners, and
an increase of a heating power is provided in a range of 5% to 30% in a time period of 0.5 to 5 seconds in order to accelerate adhesion properties of the joining partners in a third temperature treatment phase,
wherein a power input is provided in the first phase in a range between 150 and 350 W, wherein a power input in the second phase is provided in a range between 160 and 400 W and a power input in the third phase is between 170 and 500 W at the most, and
wherein the third temperature treatment phase terminates when an even formation of soldering fillets is detectable between the joining partners.

2. The method according to claim 1,
**characterized in that**
strand end sleeves, soldering bridges or soldering bases are used for an electrical connecting device.

3. The method according to one of the preceding claims,
**characterized in that**
a temperature range of the first treatment range is essentially between 90° C and 120° C and a temperature range of the second temperature treatment phase is between greater than 120° C and 200° C.

4. The method according to one of the preceding claims,
**characterized in that**
the temperature treatment phases include a constant temperature phase.

## Revendications

1. Procédé pour la mise en oeuvre technologiquement optimisée de liaisons brasées exemptes de plomb, l'un au moins des partenaires d'assemblage fournissant l'apport de brasage nécessaire pour la liaison,
dans lequel
l'un des partenaires d'assemblage est une surface métallique déposée sur un matériau de verre et un autre des partenaires d'assemblage est un moyen de connexion électrique constitué par un alliage fer - nickel, **caractérisé en ce que**
pour activer l'apport de brasage, on utilise un flux, et la jonction électrique et mécanique s'effectue par un processus de brasage par effet de chaleur et par fusion du mélange d'apport de brasage et de flux, y compris une phase de refroidissement successive,
les partenaires d'assemblage et l'apport de brasage sont chauffés jusqu'à une température inférieure à la température d'activation de l'apport de brasage et du flux, dans une première phase de traitement thermique dans la plage temporelle de 0,5 à 3 secondes, ensuite s'effectue un autre échauffement à une température supérieure à la température d'activation du flux jusqu'à la plage supérieure du trajet de fusion de l'apport de brasage, dans une seconde phase de traitement thermique dans la plage temporelle de 0,5 à 4 secondes, l'apport de brasage fond et commence à se lier avec les partenaires d'assemblage respectifs, et
dans le but d'une accélération du comportement d'adhérence des partenaires d'assemblage, on réalise une augmentation de la puissance ou de l'énergie thermique, appliquée jusqu'alors, encore de 5 % à 30 %, dans une troisième phase de traitement thermique dans la plage temporelle de 0,5 à 5 secondes,
une évolution de puissance dans la première phase est dans la plage entre 150 et 350 Watt, l'évolution de puissance dans la seconde phase est dans la plage entre 160 et 400 Watt, et la plage de puissance dans la troisième phase est dans la plage entre 170 et 500 Watt au maximum, et
la troisième phase de traitement thermique est terminée lorsqu'une réalisation régulière des gorges de brasage entre les partenaires d'assemblage est discernable.

2. Procédé selon la revendication 1,
**caractérisé en ce que**
en tant que moyen de connexion électrique, on utilise des douilles d'extrémité de brin, des ponts de brasage ou des pieds de brasage.

3. Procédé selon l'une des revendications précédentes,
**caractérisé en ce que**
la plage de température de la première phase de traitement est comprise entre sensiblement 90° et 120°, et la plage de température de la seconde phase de traitement est comprise entre > 120° et 200°.

4. Procédé selon l'une des revendications précédentes,
**caractérisé en ce que**
les phases de traitement thermique incluent une phase de maintien de température.
